# EUROPEAN PATENT SPECIFICATION

(11) **EP 3 240 373 B1**
(45) Date of publication and mention of the grant of the patent: **03.04.2019**
(21) Application number: 16198912.4
(22) Date of filing: 15.11.2016
(51) Int. Cl.: H05K 5/00, H04M 1/02, H05K 9/00, H04M 1/18

(54) **MIDDLE FRAME OF MOBILE TERMINAL AND MOBILE TERMINAL**
MITTELRAHMEN EINES MOBILEN ENDGERÄTS UND MOBILES ENDGERÄT
STRUCTURE INTERMÉDIAIRE DE TERMINAL MOBILE ET TERMINAL MOBILE

(30) Priority: 29.04.2016 CN 201610282788
(43) Date of publication of application: 01.11.2017
(73) Proprietor: Beijing Xiaomi Mobile Software Co., Ltd., Beijing 100085 (CN)
(72) Inventor: Jiang, Zhongsheng, Beijing, Beijing 100085 (CN); Liu, Dan, Beijing, Beijing 100085 (CN); Li, Guosheng, Beijing, Beijing 100085 (CN)
(74) Representative: dompatent von Kreisler Selting Werner - Partnerschaft von Patent- und Rechtsanwälten mbB

(56) References cited:
- EP-A1- 2 742 674
- EP-A2- 2 176 049
- US-A1- 2012 133 608

## Description

### TECHNICAL FIELD

The disclosure relates generally to the art of mobile terminals and, more particularly, to a middle frame of mobile terminal and a mobile terminal.

### BACKGROUND

With the development of the terminal technology, screen sizes of the mobile terminals are larger and larger. Though a large screen may provide a broader operative space and screen sight for a user, the one-hand operative of the mobile terminal for the user is becoming lower. Thus, edge touch control is coming into sight. However, the touch control signal for acting the edge touch control is obtained through the detection of a touch sensor of the mobile terminal, and the strength of the touch control signal is dependent from the middle frame of mobile terminal. The middle frame of mobile terminal means a structure for separating a touch control assembly and a battery of the mobile terminal, wherein the touch sensor is included in the touch control assembly.

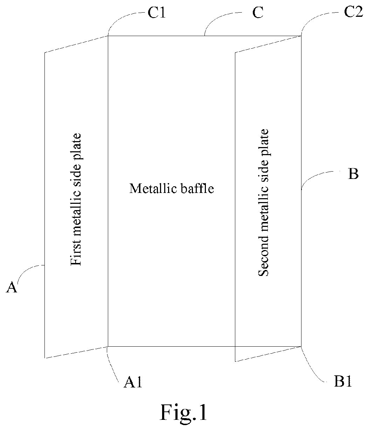

In the related arts, in order to prevent the static electricity generated at the battery side from entering the touch control assembly and causing undesirable effects to the touch control assembly, a metallic middle frame is commonly adopted as the middle frame of mobile terminal. Please refer to Fig. 1, in which the metallic middle frame may commonly include two metallic side plates and one metallic baffle. Here, a long side A1 of a first metallic side plate A and a first long side C1 of a metallic baffle C are connected to each other, a long side B1 of a second metallic side plate B and a second long side C2 of a metallic baffle C are connected to each other, and a first metallic side plate A and a second metallic side plate B are positioned at the same side of the metallic baffle C and are respectively perpendicular to the metallic baffle.

D1 discloses a touch display assembly structure, which includes a capacitor type touch panel, a display panel, a plastic side frame and an adhesive layer. D2 discloses an electronic device with sidewall displays, which contains flexible displays that are bent to form displays on multiple surfaces of the device. D3 discloses a method for forming a dual layer housing.

### SUMMARY

To overcome the problems existing in the relative arts, the present disclosure provides a middle frame of a mobile terminal and a mobile terminal.

A middle frame of a mobile terminal according to an embodiment of this disclosure is a middle frame according to claim 1.

Various respective aspects and features of the invention are defined in the appended claims.

The technical solutions provided by the present disclosure may include the following advantageous effects: since the middle frame of the mobile terminal comprises the first non-metallic side plate and the second non-metallic side plate, when the mobile terminal is gathering the touch control signal, the first non-metallic side plate and the second non-metallic side plate will not shield the touch control signal, such that the mobile terminal can easily gather the touch control signal improving the efficiency for gathering the touch control signal, and improving the accuracy for gathering the touch control signal at the same time.

It is to be understood that both the foregoing general description and the following detailed description are exemplary and explanatory only and are not restrictive of the disclosure.

### BRIEF DESCRIPTION OF THE DRAWINGS

The accompanying drawings, which are incorporated in and constitute a part of this specification, illustrate embodiments consistent with the disclosure and, together with the description, serve to explain the principles of the disclosure.
Fig. 1 is a structural schematic view showing a metallic middle frame according to an exemplary embodiment.
Fig. 2 is a structural schematic view showing a middle frame of mobile terminal according to an exemplary embodiment.
Fig. 3 is a structural schematic view showing another middle frame of mobile terminal according to an exemplary embodiment.
Fig. 4 is a side view showing a first side plate according to an exemplary embodiment.
Fig. 5 is a side view showing a second side plate according to an exemplary embodiment.
Fig. 6 is a figure showing the positional relationship between a first metallic portion and a touch sensor according to an exemplary embodiment.
Fig. 7 is a figure showing the positional relationship between a second metallic portion and a touch sensor according to an exemplary embodiment.

### Reference signs:

- A:: first metallic side plate;
- B:: second metallic side plate;
- C:: metallic baffle;
- A1:: long side of the first metallic side plate;
- B1:: long side of the second metallic side plate;
- C1:: first long side of the metallic baffle;
- C2:: second long side of the metallic baffle;
- 1:: first non-metallic side plate;
- 2:: second non-metallic side plate;
- 3:: metallic baffle;
- 11:: long side of the first non-metallic side plate;
- 21:: long side of the second non-metallic side plate;
- 31:: first long side of the metallic baffle;
- 32:: second long side of the metallic baffle;
- 4:: first side plate;
- 5:: second side plate;
- 6:: touch sensor;
- 41:: first metallic portion;
- 42:: first non-metallic portion;
- 51:: second metallic portion;
- 52:: second non-metallic portion;
- 411:: long side of the first metallic portion;
- 511:: long side of the second metallic portion.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the disclosure. Instead, they are merely examples of devices and methods consistent with some aspects related to the disclosure as recited in the appended claims.

An application environment of the present disclosure will be introduced before the detailed explanation to the embodiments of the present disclosure. At present, the screen size of the mobile terminal is becoming larger and larger. Though a large screen may provide a broader operative space and screen sight for a user, the one-hand operative of the mobile terminal for the user is becoming lower. To solve this problem, edge touch control is being added into the mobile terminal gradually. Here, the touch control signal for acting the edge touch control is obtained through the detection of a touch sensor of the mobile terminal. At the same time, in order to prevent the static electricity generated at the battery side from entering the touch control assembly, a metallic middle frame is commonly adopted as the middle frame of mobile terminal. However, since the metallic middle frame shields the touch control signal to an extent, a part of the touch signal may be shielded when the metallic middle frame is preventing the static electricity from entering the touch control assembly, causing a decreased efficiency and accuracy for the gathered touch signal of the mobile terminal. Thus, the embodiment of the present disclosure provides a middle frame of mobile terminal, so as to improve the efficiency and accuracy for the gathered touch signal of the mobile terminal.

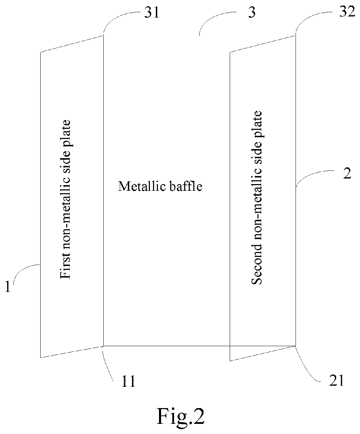

Fig. 2 is a structural schematic view showing a middle frame of mobile terminal according to an exemplary embodiment. As show in Fig. 2, the middle frame of mobile terminal comprises a first non-metallic side plate 1, a second non-metallic side plate 2 and a metallic baffle 3.

A long side 11 of the first non-metallic side plate 1 and a first long side 31 of the metallic baffle 3 are connected to each other, a long side 21 of the second non-metallic side plate 2 and a second long side 32 of the metallic baffle 3 are connected to each other, the first non-metallic side plate 1 and the second non-metallic side plate 2 are positioned at the same side of the metallic baffle 3 and are respectively perpendicular to the metallic baffle 3.

Since the middle frame of mobile terminal comprises the first non-metallic side plate 1 and the second non-metallic side plate 2, i.e., the both side plates in the middle frame of mobile terminal are non-metallic side plates, when the mobile terminal is gathering the touch control signal, the first non-metallic side plate 1 and second non-metallic side plate 2 decrease the shielding to the touch control signal, such that the mobile terminal can easily gather the touch control signal, improving the efficiency for gathering the touch control signal, and the accuracy for gathering the touch control signal.

It should be noted that, first non-metallic side plate 1 can be formed by a inject-moulding material and, of course, can be formed by other non-metallic materials, such as ceramics, glass, and etc. The embodiments of the present disclosure are not limited to this.

For the similar reason, the second non-metallic side plate 2 can be formed by the inject-moulding material or other non-metallic materials, as well. The embodiments of the present disclosure are not limited to this.

It should be also noted that, in the embodiment of the present disclosure, the first non-metallic side plate 1 and the second non-metallic side plate 2 may be respectively perpendicular to the metallic side plate 3, and, of course, may be not perpendicular thereto. The embodiments of the present disclosure are not limited to this.

In the embodiments of the present disclosure, since the middle frame of mobile terminal comprises the first non-metallic side plate and the second non-metallic side plate, and the first non-metallic side plate and the second non-metallic side plate are formed by the non-metallic material, the first non-metallic side plate and second non-metallic material decrease the shielding to the touch control signal. Therefore, when the mobile terminal is gathering the touch control signal, the touch control signal may be easily gathered, improving the efficiency for gathering the touch control signal, and improving the accuracy for gathering the touch control signal at the same time.

The embodiment of the present disclosure provides a mobile terminal, which mobile terminal comprises the middle frame of mobile terminal provided by the above embodiment.

It should be noted that, the mobile terminal may not only comprise the middle frame of mobile terminal of the above embodiment, but also comprise a touch sensor and other elements, such as, a processor, an antenna, etc. The embodiments of the present disclosure are not limited to this.

In the embodiments of the present disclosure, since the mobile terminal comprises the middle frame of mobile terminal for easily gathering the touch control signal, the mobile terminal can gather the touch control signal easily, so as to improve the efficiency for gathering the touch control signal.

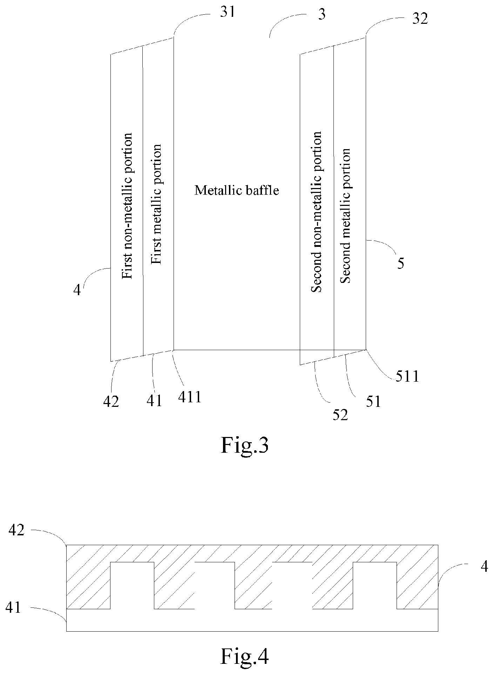

Fig. 3 is a structural schematic view showing another middle frame of mobile terminal according to an exemplary embodiment. Please refer to Fig. 3, in which the middle frame of mobile terminal comprises a first side plate 4, a second side plate 5 and a metallic baffle 3, and the first side plate 4 comprises a first metallic portion 41 and a first non-metallic portion 42, the second side plate 5 comprises a second metallic portion 51 and a second non-metallic portion 52.

A long side 411 of the first metallic portion 41 and a first long side 31 of the metallic baffle 3 are connected to each other. A side of the first metallic portion 41 opposite the long side 411 of the first metallic portion 41 is provided with a first non-metallic portion 42. A long side 511 of the second metallic portion 51 and a second long side 32 of the metallic baffle 3 are connected to each other. A side of the second metallic portion 51 opposite the long side 511 of the second metallic portion 51 is provided with a second non-metallic portion 52.

Since the first side plate 4 comprises the first non-metallic portion 42, the second side plate 5 comprises the second non-metallic portion 52, and the first non-metallic portion 42 is positioned at the side opposite the long side 411 of the first metallic portion 41, the second non-metallic portion 52 is positioned at the side opposite the long side 511 of the second metallic portion 51, i.e., the first non-metallic portion 42 is the portion in the first side plate 4 distant to the metallic baffle 3, and the second non-metallic portion 52 is the portion in the second side plate 5 distant to the metallic baffle 3, when the mobile terminal is gathering the touch control signal, the first side plate 4 and the second side plate 5 may decrease the shielding to the touch control signal, such that the mobile terminal may gather the touch control signal easily, improving the efficiency for gathering the touch control signal. At the same time, since the first side plate 4 comprises the first metallic portion 41, and the second side plate 5 comprises the second metallic portion 51, the first side plate 4 and the second side plate 5 can ensure the sturdy structure for the middle frame of mobile terminal and, at the same time, can effectively prevent the static electricity generated at the battery side from entering the touch control assembly, so as to improve the accuracy for gathering the touch control signal.

Here, when the first non-metallic portion 42 is positioned at the side opposite the long side 411 of the first metallic portion 41, and the second non-metallic portion 52 is positioned at the side opposite the long side 511 of the second metallic portion 51, the first metallic portion 41 and the first non-metallic portion 42 are in a same plane, and the second metallic portion 51 and the second non-metallic portion 52 are in another same plane.

It should be noted that, the first non-metallic portion 42 may be formed by injection-moulding material, ceramic, glass and other non-metallic materials. The embodiments of the present disclosure are not limited to this.

It should be also noted that, the second non-metallic portion 52 may be formed by injection-moulding material, ceramic, glass and other non-metallic materials, as well. The embodiments of the present disclosure are not limited to this.

Please refer to Fig. 3, in which each of the first metallic portion 41 and the first non-metallic portion 42 is a cuboid side plate. For the similar reason, each of the second metallic portion 51 and the second non-metallic portion 52 is a cuboid side plate.

It should be noted that, when each of the first metallic portion 41 and the first non-metallic portion 42 is the cuboid side plate, and each of the second metallic portion 51 and the second non-metallic portion 52 the cuboid side plate, the middle frame of mobile terminal can be conveniently mounted, and the appurtenance of the mobile terminal can be ensured to an extent.

It should be also noted that, the side surface of the first metallic portion 41 and the first non-metallic portion 42 may be a cuboid side plate, and may be a side plate of other shapes, as well. The embodiments of the present disclosure are not limited to this.

For the similar reason, the side surface of the second metallic portion 51 and the second non-metallic portion 52 may be a cuboid side plate, and may be a side plate of other shapes, as well. The embodiments of the present disclosure are not limited to this.

Fig. 4 is a side view showing a first side plate according to an exemplary embodiment. Please refer to Fig. 4, in which the first metallic portion 41 comprises at least one groove structure, the first non-metallic portion 42 comprises at least one protrusion structure, and the at least one protrusion structure of the first non-metallic portion 42 is imbedded in the at least one groove structure of the first metallic portion 41.

Here, when the at least one protrusion structure of the first non-metallic portion 42 is imbedded in the at least one groove structure of the first metallic portion 41, the middle frame of mobile terminal has a sturdy structure, such that the elements in the mobile terminal can be well fixed.

It should be noted that, the at least one groove structure may be a groove having a rectangular shape, or having another shape, such as a zigzag shape, a waving shape, and etc. Similarly, the at least one protrusion structure may be a protrusion having a rectangular shape, or having another shape, such as a zigzag shape, a waving shape, and etc. The embodiments of the present disclosure are not limited to this.

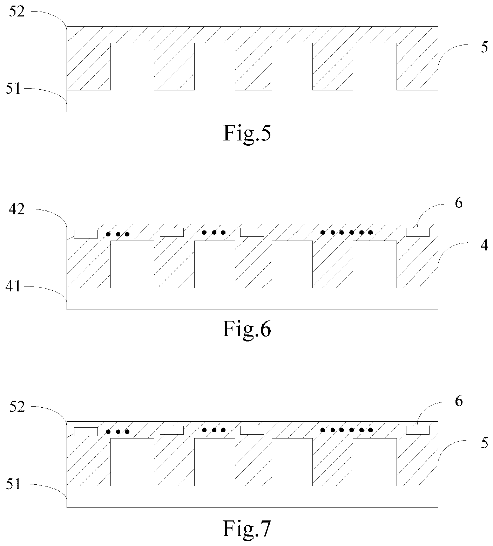

In addition, Fig. 5 is a side view showing a second side plate according to an exemplary embodiment. Similarly, the second metallic portion 51 comprises at least one groove structure, the second non-metallic portion 52 comprises at least one protrusion structure, and the at least one protrusion structure of the second non-metallic portion 52 is imbedded in the at least one groove structure of the second metallic portion 51.

Here, when the at least one protrusion structure of the second non-metallic portion 52 is imbedded in the at least one groove structure of the second metallic portion 51, the middle frame of mobile terminal has a sturdy structure, such that the elements in the mobile terminal can be well fixed.

It should be noted that, the at least one groove structure may be a groove having a rectangular shape, or having another shape, such as a zigzag shape, a waving shape, and etc. Similarly, the at least one protrusion structure may be a protrusion having a rectangular shape, or having another shape, such as a zigzag shape, a waving shape, and etc. The embodiments of the present disclosure are not limited to this.

It should be also noted that, based on the above description, the embodiments of the present disclosure are not specifically limited to the shapes of the first non-metallic portion 42 and the first metallic portion 41, so long as the touch sensor 6 is close to the first non-metallic portion 42 and distant from the first metallic portion 41. For the similar reason, the embodiments of the present disclosure are not specifically limited to the shapes of the second non-metallic portion 52 and the second metallic portion 51, so long as the touch sensor 6 is close to the second non-metallic portion 52 and distant from the second metallic portion 51.

Please refer to Fig. 6, in which each of the at least one groove structure of the first metallic portion 41 has an opening positioned corresponding to the position of one of the touch sensors 6 of the mobile terminal. Please refer to Fig. 7, in which each of the at least one groove structure of the second metallic portion 51 has an opening positioned corresponding to the position of one of the touch sensors 6 of the mobile terminal.

Here, the touch sensors are positioned at the openings of each of the at least one groove structures of the first metallic portion 41, and the touch sensors are positioned at the openings of each of the at least one groove structure of the second metallic portion 5, i.e., the first non-metallic portion 42 is provided with the touch sensors 6 correspondingly, and the second non-metallic portion 52 is provided with the touch sensors 6 correspondingly, as well.

It should be noted that, when the touch sensor 6 is positioned at the opening of each of the groove structures, the touch sensor 6 has a position corresponding to that of the first non-metallic portion 42, and the touch sensor is positioned relatively distant from the first metallic portion 41, so as to decrease the shielding to the touch control signal caused by the first metallic portion. For the similar reason, when the touch sensor 6 is positioned in the opening of each of the groove structures of the second metallic portion, the touch sensor 6 has a position corresponding to that of the second non-metallic portion, and the touch sensor 6 is positioned relatively distant from the second metallic portion, so as to decrease the shielding to the touch control signal caused by the second metallic portion, and the efficiency of the mobile terminal for gathering the touch control signal can be improved.

In the embodiments of the present disclosure, since the first side plate comprises the first non-metallic portion, the second side plate comprises the second non-metallic portion, and the first non-metallic portion is positioned at the side opposite the long side of the first metallic portion, the second non-metallic portion is positioned at the side opposite the long side of the second metallic portion, i.e., the first non-metallic portion is the portion in the first side plate distant from the metallic baffle, and the second non-metallic portion is the portion in the second side plate distant from the metallic baffle, when the mobile terminal is gathering the touch control signal, the first side plate and the second side plate decrease the shielding to the gathering for the touch control signal, such that the mobile terminal can easily gather the touch control signal, and the efficiency of gathering the touch control signal is improved. At the same time, since the first side plate comprises the first metallic portion, and the second side plate comprises the second metallic portion, the first side plate and the second side plate can ensure the sturdy structure of the middle frame of mobile terminal and, at the same time, can effectively prevent the static current generated at the battery side from entering the touch control assembly, so as to improve the accuracy for gathering the touch control signal.

The embodiment of the present disclosure provides a mobile terminal, which mobile terminal comprises the middle frame of mobile terminal provided by the above-mentioned embodiments.

Here, the mobile terminal further comprises the touch sensor provided by the above-mentioned embodiments.

It should be noted that, the mobile terminal may not only comprise the middle frame of mobile terminal and the touch sensor of the above-mentioned embodiment, but also comprise other elements, such as, a processor, an antenna, and etc. The embodiments of the present disclosure are not limited to this.

In the embodiments of the present disclosure, since the mobile terminal comprises the middle frame of mobile terminal for easily gathering the touch control signal, the mobile terminal can gather the touch control signal easily, so as to improve the efficiency for gathering the touch control signal.

## Claims

1. A middle frame of a mobile terminal comprises a first side plate (4), a second side plate (5) and a metallic baffle (3), and the first side plate (4) comprises a first metallic portion (41) and a first non-metallic portion (42), the second side plate (5) comprises a second metallic portion (51) and a second non-metallic portion (52);
a long side (411) of the first metallic portion (41) and a first long side (31) of the metallic baffle (3) are connected to each other, a side in the first metallic portion (41) opposite the long side (411) of the first metallic portion (41) is provided with the first non-metallic portion (42), a long side (511) of the second metallic portion (51) and a second long side (32) of the metallic baffle (3) are connected to each other, and a side of the second metallic portion (51) opposite the long side (511) of the second metallic portion (51) is provided with the second non-metallic portion (52);
wherein the first metallic portion (41) comprises at least one groove structure, the first non-metallic portion (42) comprises at least one protrusion structure, and the at least one protrusion structure of the first non-metallic portion (42) is imbedded in the at least one groove structure of the first metallic portion (41),
**characterized in that** each of the at least one groove structures of the first metallic portion (41) has an opening positioned corresponding to the position of a touch sensor (6) of the mobile terminal, the touch sensor is positioned relatively distant from the metallic portion so as to decrease the shielding to the touch control signal.

2. The middle frame of mobile terminal according to claim 1, **characterized in that** each of the first metallic portion (41) and the first non-metallic portion (42) is a cuboid side plate.

3. The middle frame of mobile terminal according to claim 1 or 2, **characterized in that** each of the second metallic portion (51) and the second non-metallic portion (52) is cuboid side plate.

4. The middle frame of mobile terminal according to any one of claims 1-3, **characterized in that** the second metallic portion (51) comprises at least one groove structure, the second non-metallic portion (52) comprises at least one protrusion structure, and the at least one protrusion structure of the second non-metallic portion (52) is imbedded in the at least one groove structure of the second metallic portion (51).

5. The middle frame of mobile terminal according to claim4, **characterized in that** each of the at least one groove structures of the second metallic portion (51) has an opening positioned corresponding to the position of the touch sensor (6) of the mobile terminal.

6. A mobile terminal, **characterized in that** the mobile terminal comprises the middle frame according to any one of claims 1-5.

## Patentansprüche

1. Mittelrahmen eines mobilen Endgeräts, mit einer ersten Seitenplatte (4), einer zweiten Seitenplatte (5) und einer metallischen Blende (3), und wobei die erste Seitenplatte (4) einen ersten metallischen Bereich (41) und einen ersten nicht-metallischen Bereich (42) aufweist, wobei die zweite Seitenplatte (5) einen zweiten metallischen Bereich (51) und einen zweiten nicht-metallischen Bereich (52) aufweist;
wobei eine lange Seite (411) des ersten metallischen Bereichs (41) und eine erste lange Seite (31) der metallischen Blende (3) miteinander verbunden sind, wobei eine Seite in dem ersten metallischen Bereich (41), die der langen Seite (411) des ersten metallischen Bereichs (41) entgegengesetzt ist, mit dem ersten nicht-metallischen Bereich (42) versehen ist, wobei eine lange Seite (511) des zweiten metallischen Bereichs (51) und eine zweite lange Seite (32) der metallischen Blende (3) miteinander verbunden sind, und wobei eine Seite des zweiten metallischen Bereichs (51), die der langen Seite (511) des zweiten metallischen Bereichs (51) entgegengesetzt ist, mit dem zweiten nicht-metallischen Bereich (52) versehen ist;
wobei der erste metallische Bereich (41) mindestens eine Rillenstruktur aufweist, der erste nicht-metallische Bereich (42) mindestens eine Vorsprungsstruktur aufweist, und die mindestens eine Vorsprungsstruktur des ersten nicht-metallischen Bereichs (42) in die mindestens eine Rillenstruktur des ersten metallischen Bereichs (41) eingebettet ist,
**dadurch gekennzeichnet, dass** jede der mindestens einen Rillenstrukturen des ersten metallischen Bereichs (41) eine Öffnung aufweist, die der Position eines Touch-Sensors (6) des mobilen Endgeräts entsprechend angeordnet ist, wobei der Touch-Sensor relativ entfernt von dem metallischen Bereich positioniert ist, um die Abschirmung des Touch-Steuersignals zu verringern.

2. Mittelrahmen eines mobilen Endgeräts nach Anspruch 1, **dadurch gekennzeichnet, dass** sowohl der erste metallische Bereich (41), als auch der erste nicht-metallische Bereich (42) eine quaderförmige Seitenplatte ist.

3. Mittelrahmen eines mobilen Endgeräts nach Anspruch 1 oder 2, **dadurch gekennzeichnet, dass** sowohl der zweite metallische Bereich (51), als auch der zweite nicht-metallische Bereich (52) eine quaderförmige Seitenplatte ist.

4. Mittelrahmen eines mobilen Endgeräts nach einem der Ansprüche 1 - 3, **dadurch gekennzeichnet, dass** der zweite metallische Bereich (51) mindestens eine Rillenstruktur aufweist, der zweite nicht-metallische Bereich (52) mindestens eine Vorsprungsstruktur aufweist, und die mindestens eine Vorsprungsstruktur des zweiten nicht-metallischen Bereichs (52) in die mindestens eine Rillenstruktur des zweiten metallischen Bereichs (51) eingebettet ist.

5. Mittelrahmen eines mobilen Endgeräts nach Anspruch 4, **dadurch gekennzeichnet, dass** jede der mindestens einen Rillenstrukturen des zweiten metallischen Bereichs (51) eine Öffnung aufweist, die der Position des Touch-Sensors (6) des mobilen Endgeräts entsprechend angeordnet ist.

6. Mobiles Endgerät, **dadurch gekennzeichnet, dass** das mobile Endgerät den Mittelrahmen nach einem der Ansprüche 1-5 aufweist.

## Revendications

1. Structure intermédiaire de terminal mobile comprenant une première plaque latérale (4), une deuxième plaque latérale (5) et un déflecteur métallique (3), et la première plaque latérale (4) comprenant une première partie métallique (41) et une première partie non métallique (42), la deuxième plaque latérale (5) comprenant une deuxième partie métallique (51) et une deuxième partie non métallique (52);
un côté long (411) de la première partie métallique (41) et un premier côté long (31) du déflecteur métallique (3) sont connectés l'un à l'autre, un côté de la première partie métallique (41) opposé au côté long (411) de la première partie métallique (41) est pourvu de la première partie non métallique (42), un côté long (511) de la deuxième partie métallique (51) et un deuxième côté long (32) du déflecteur métallique (3) sont connectés l'un à l'autre et un côté de la deuxième partie métallique (51) opposé au côté long (511) de la deuxième partie métallique (51) est pourvu de la deuxième partie non métallique (52);
dans laquelle la première partie métallique (41) comprend au moins une structure de rainure, la première partie non métallique (42) comprend au moins une structure de saillie, et l'au moins une structure de saillie de la première partie non métallique (42) est incorporée dans l'au moins une structure de rainure de la première partie métallique (41),
**caractérisée par le fait que** chacune des au moins une structure de rainure de la première partie métallique (41) présente une ouverture positionnée de manière correspondante à la position d'un capteur tactile (6) du terminal mobile, le capteur tactile est positionné de manière relativement distante de la partie métallique de manière à diminuer le blindage au signal de commande tactile.

2. Structure intermédiaire de terminal mobile selon la revendication 1, **caractérisée par le fait que** chacune de la première partie métallique (41) et de la première partie non métallique (42) est une plaque latérale cuboïde.

3. Structure intermédiaire de terminal mobile selon la revendication 1 ou 2, **caractérisée par le fait que** chacune de la deuxième partie métallique (51) et de la deuxième partie non métallique (52) est une plaque latérale cuboïde.

4. Structure intermédiaire de terminal mobile selon l'une quelconque des revendications 1 à 3, **caractérisée par le fait que** la deuxième partie métallique (51) comprend au moins une structure de rainure, la deuxième partie non métallique (52) comprend au moins une structure de saillie, et l'au moins une structure de saillie de la deuxième partie non métallique (52) est incorporée dans l'au moins une structure de rainure de la deuxième partie métallique (51).

5. Structure intermédiaire de terminal mobile selon la revendication 4, **caractérisée par le fait que** chacune des au moins une structure de rainure de la deuxième partie métallique (51) présente une ouverture positionnée de manière correspondante à la position du capteur tactile (6) du terminal mobile.

6. Terminal mobile, **caractérisé par le fait que** le terminal mobile comprend la structure intermédiaire selon l'une quelconque des revendications 1 à 5.
